# EUROPÄISCHE PATENTANMELDUNG

(11) **EP 1 072 696 A1**
(43) Veröffentlichungstag der Anmeldung: **31.01.2001**
(21) Anmeldenummer: 00114462.5
(22) Anmeldetag: 06.07.2000
(51) Int. Cl.: C30B 11/00, C30B 29/06

(54) **Vorrichtung zum Herstellen von gerichtet erstarrten Blöcken und Betriebsverfahren hierfür**

(30) Priorität: 26.07.1999 DE 19934940
(71) Anmelder: ALD Vacuum Technologies AG, 63450 Hanau (DE)
(72) Erfinder: Franz, Hugo, 63743 Aschaffenburg (DE); Zuckerstätter, Erich, 63571 Gelnhausen (DE)
(74) Vertreter: Zapfe, Hans, Dipl.-Ing.

(57) **Zusammenfassung**

Eine Vorrichtung zum Herstellen von gerichtet erstarrten Blöcken, insbesondere aus Silizium, besitzt eine gasdichte Kristallisationskammer (1), eine Kokille (6) mit einer Kokillenöffnung (6a), Kokillenwänden und einem Kokillenboden, eine Deckenheizeinrichtung (13) für die Beheizung der Kokillenöffnung (6a), eine Bodenheizeinrichtung (14) für die Beheizung des Kokillenbodens und eine Wärmedämmeinrichtung (9), die die Kokille (6) und die Heizeinrichtungen umgibt. Die Kokille ist dafür ausgelegt, die einchargierten Feststoffe aufzuschmelzen. Zur Schaffung einer kompakten Anlage für die erschütterungsfreie großtechnische Produktion von Blöcken mit großem Querschnitt und großen Kristallen durch Aufschmelzen von Chargen in der Kokille (6) selbst und mit kurzen Chargierzeiten sind
a) die Kristallisationskammer (1) entlang einer Trennfuge (4) in ein stationäres Kammerunterteil (2) und ein bewegliches Kammeroberteil (3) unterteilt,
b) die Bodenheizeinrichtung (14) mit einem Boden (10) der Wärmedämmeinrichtung (9) und die Kokille (6) im Kammerunterteil (2) angeordnet,
c) die Deckenheizeinrichtung (13) für Beheizung der Kokillenöffnung und ein Deckel (12) der Wärmedämmeinrichtung (9) am Kammeroberteil (3) befestigt und mit diesem verfahrbar, und
d) die Kokille (6) durch Verfahren des Kammeroberteils (3) an mindestens einer Umfangsseite freilegbar.

## Beschreibung

Die Erfindung betrifft eine Vorrichtung zum Herstellen von gerichtet erstarrten Blöcken nach dem Oberbegriff des Patentanspruchs 1.

Eine solche Vorrichtung dient bevorzugt, aber nicht ausschließlich zum Herstellen von Blöcken aus Silizium für die Herstellung von Solarzellen..

Gußblöcke und Formgußteile mit gerichteter Erstarrung, d.h. gezieltem Kristallwachstum, gewinnen wegen ihrer verbesserten Eigenschaften zunehmend an Bedeutung. Die reproduzierbare Herstellung in großtechnischem Maßstab ist jedoch schwierig. Auf dem Gebiet der Photovoltaik, d.h. bei der Herstellung von Ausgangsmaterial (Wafern) für Solarzellen, hängt deren elektrischer Wirkungsgrad entscheidend von der Größe der Kristalle ab, die parallel zueinander verlaufen und einen möglichst großen Querschnitt haben sollten.

Dieser parallele Verlauf der Kristalle (Dendriten) setzt jedoch voraus, daß eine möglichst ebene Phasengrenze fest/flüssig allmählich von unten nach oben durch den Ingot wandert, die Verunreinigungen vor sich her schiebt und unter sich einen Einkristall oder großkristallinen Polykristall aufbaut. Eine ebene Phasengrenze fordert jedoch ein möglichst großes Verhältnis von vertikalen zu horizontalen Temperaturgradienten.

Beim Zonenschmelzen nach Czochralski wird ein polykristalliner Ingot aus Silizium senkrecht aufgehängt, und eine den Ingot umgebend Heizspule wird achsparallel von unten nach oben bewegt, so daß die Phasengrenze fest/flüssig der relativen Spulenbewegung folgt. Der Ingotquerschnitt ist jedoch begrenzt, und das Verfahren läuft nur langsam ab, so daß eine Steigerung der Produktionsmenge eine Vielzahl derartiger Vorrichtungen erforderlich macht.

Durch die EP 0 021 385 A1 ist es auch bekannt, Siliziumstäbe im Stranggußverfahren dadurch herzustellen, daß man den Ingot mittels einer angetriebenen Kühlplatte kontinuierlich aus einer unten offenen, beheizten Stranggußkokille abzieht und von oben aus einem Schmelzbehälter mit einem Bodenauslauf geregelt flüssiges Silizium nachchargiert. Die Bauhöhe ist jedoch beträchtlich, und der Ingot muß zur Vermeidung einer Reaktion mit dem Kokillenwerkstoff von einer Schutzschmelze umgeben sein, die mit Silizium nicht mischbar ist und beispielhaft aus Erdalkalifluoriden besteht.

Bei diesem Verfahren ändert sich jedoch laufend das Verhältnis von vertikalem zu horizontalem Temperaturgradienten, weil der Einfluß der Bodenkühlung mit wachsender Blocklänge abnimmt und der Wärmeverlust durch radiale Strahlung von der freigegebenen Blockoberfläche immer mehr zunimmt. Selbst eine anfänglich ebene Phasengrenze wird dadurch allmählich zu einer paraboloidförmigen Phasengrenze, und da das Kristallwachstum stets senkrecht zur Phasengrenze verläuft, haben die Kristalle schließlich eine radial konvergierende Richtung und nehmen an Größe ab. Außerdem ist die Regelung eines solchen Verfahrens aufwendig und die Produktivität gleichfalls gering. Schließlich leidet das Verfahren unter der Gefahr einer Störung des Kristallisationsprozesses durch Erschütterungen des Bewegungsmechanismus.

Zur Erhöhung der Produktivität ist es durch die US 3 601 179 A weiterhin bekannt, eine fahrbare Schmelzkammer mit einem Kipptiegel zwischen zwei Reihen von Kristallisationskammern mit Standkokillen zu verfahren, die von Heizspulen umgeben sind und auf Kühlplatten stehen. Zum Abgießen der Siliziumschmelze wird die Schmelzkammer mit jeweils einer der Kristallisationskammern durch ein Schleusensystem von Vakuumschiebern verbunden, um den Abguß und die Kristallisation unter Vakuum oder einem Schutzgas durchführen zu können. Um die Standkokille entnehmen zu können, muß zunächst die Heizspule mittels eines Hydraulikantriebs um mehr als das Höhenmaß der Kokille angehoben werden, was zunächst einmal mindestens die doppelte Bauhöhe der Kristallisationskammern erforderlich macht, außerdem besitzt jede Kristallisationskammer eine eigene seitliche Tür für die Entnahme der Standkokille. Die Anlage ist dadurch sehr aufwendig und bei den häufigen Inspektionen und eventuellen Reparaturen an der Schmelzkammer nicht betriebsbereit.

Durch die DE 33 23 896 C2 ist es ferner bekannt, einen Tiegel bzw. eine Kokille mit ihrer Boden-Kühleinrichtung ortsfest in einer gemeinsamen Wärmedämmung unterzubringen, die im Bereich der Kokille außen von einer Induktionsspule umgeben ist. Mit dieser wird auch das Aufschmelzen der zunächst festen Charge bewirkt. Zur Erzeugung einer ebenen Phasengrenze wird das Verhältnis von Wandheizung zu Bodenkühlung der Kokille laufend verändert. Auch hierbei ist die Produktivität gering, zumal auch die Entnahme der Kokille mit dem erstarrten Ingot zeitaufwendig ist.

Die EP 218 088 B1 offenbart gleichfalls den Einfluß einer zeitlichen Veränderung des Wärmehaushalts auf die gerichtete, bzw. kolumnare Erstarrung von Schmelzen, die zuvor in eine Kokille eingegossen wurden Dies geschieht durch eine spezielle Ausbildung der Kokillenheizung, die auf dem Umfang geteilt ausgebildet sein kann, wobei für rechteckige Kokillen eine vierteilige und für runde Kokillen eine halbschalige Ausführung der Kokillenheizeinrichtung empfohlen wird. Über die Ausbildung der übrigen Teile der Vorrichtung schweigt sich die Schrift jedoch aus.

Eine Autorengruppe des ACCESS e.V. in Aachen und der BAYER AG in Krefeld-Ürdingen berichtete anläßlich der ersten WCPEC vom 5. bis 9. Dezember 1994 unter dem Titel "A VIRTUAL CRYSTALLIZATION FURNACE FOR SOLAR SILICON" über das Prinzip der gerichteten Erstarrung und ein Rechenmodell für die Auslegung einer Kristallisationsanlage. Über die Ausbildung der Vorrichtung schweigt sich das Vortragsmanuskript jedoch aus.

Die nachstehend abgehandelten Schriften sind gattungsfremd, weil bei den dort beschriebenen Verfahren und Vorrichtungen bereits vorgeschmolzenes Chargiergut in die Kokille eindosiert wird. Die Vorrichtungen und Verfahren sind kompliziert, weil hierbei Zusatzaggregate und andere Auslegungen der Kokille und der Heizeinrichtungen erforderlich sind:

Durch die DE 22 52 548 C ist es bekannt, in eine Kokille mit Decken-, Wand- und Bodenbeheizung und entsprechenden Isolierungen eine Metallschmelze dosiert einzubringen, sei es aus einem Schmelztiegel, sei es durch Aufschmelzen eines kontinuierlich zugeführten Drahtes. Durch Verschiebung der Heizleistungen soll dabei eine waagrechte Phasengrenze flüssig/fest von unten nach oben durch den Kokilleninhalt hindurch bewegt werden, um eine gerichtete Erstarrung mit einer möglichst feinen vertikalen Dendritenstruktur zu erzielen. Die Autoren setzen sich auch mit dem Problem auseinander, daß die eindosierte Schmelze eine Störung des Erstarrungsprozesses zur Folge haben könnte, und schlagen daher vor, die Fallhöhe der Schmelze möglichst gering zu halten und das Volumen der flüssigen Phase innerhalb der Gießform praktisch konstant zu halten, beispielsweise bei einer Höhe von etwa 15 mm. Dies schließt es aus, Feststoffe in der Gießform vollständig aufzuschmelzen, und das Volumen der flüssigen Phase ständig zu verkleinern, bis der fertige Block entstanden ist, für den eine Höhe von 25 mm angegeben wird. Die Vorrichtung ist für die Herstellung großer Siliziumblöcke, wie sie für die Großproduktion von Solarsilizium mit möglichst grober Kristallstruktur bis hin zu Einkristallen gefordert wird, weder vorgesehen noch geeignet. Insbesondere stört die kontinuierliche Schmelzenchargierung dennoch den Erstarrungsvorgang, weil die Schmelze notwendigerweise überhitzt ist und punktförmig zugeführt wird. Dies kann durch eine flächige Bodenkühlung nicht ausgeglichen werden.

Durch die DE 32 20 241 A1 ist es bekannt, polykristalline Siliziumstäbe dadurch herzustellen, daß eine Siliziumschmelze in einen Tiegel eingegossen und in diesem gerichtet erstarrt wird. Auch hierbei wird kein Silizium im Tiegel aufgeschmolzen, und der erstarrte Siliziumstab ist lediglich ein Vorprodukt für ein nachfolgendes Zonenschmelzen, ein Vorgang, der nur mit sehr begrenzten Blockdurchmessern und sehr langsamen Wachstumsgeschwindigkeiten abläuft. Als Blockdurchmesser werden 30 bis 100 mm angegeben. Auch diese Vorrichtung ist für die Herstellung großer Siliziumblöcke, wie sie für die Großproduktion von Solarsilizium mit möglichst grober Kristallstruktur bis hin zu Einkristallen gefordert wird, weder vorgesehen noch geeignet.

Durch die DD 122 478 C ist es gleichfalls nur bekannt, Siliziumschmelze in einen Tiegel einzugießen und darin gerichtet zu erstarren. Als Blockabmessungen werden 100 mm x 100 mm x 70 mm und 150 mm x 150 mm x 200 mm angegeben. Auch diese Vorrichtung ist für die Herstellung großer Siliziumblöcke, wie sie für die Großproduktion von Solarsilizium mit möglichst grober Kristallstruktur bis hin zu Einkristallen gefordert wird, weder vorgesehen noch geeignet.

Durch die DE 198 31 388 A1 ist es bekannt, zur gerichteten Erstarrung einer in eine Kokille eingegossenen Schmelze über der Kokille eine Deckenheizung und unter dem Kokillenboden zunächst eine wärmeleitende Tragplatte, danach eine Struktur von Heizkörpern mit Zwischenräumen und darunter wiederum eine Wärmedämmplatte anzuordnen. Sowohl in der Tragplatte als auch in der Wärmedämmplatte und ggf. im Kokillenboden ist eine Vielzahl senkrechter jeweils fluchtender Ausnehmungen angeordnet, durch die platten-, kreuz-, stern- oder stiftförmige Kühlkörper einer heb- und senkbaren, wassergekühlten Kühlplatte bis in unmittelbare Nähe des Kokillenbodens angehoben werden können, um eine möglichst waagrechte Phasengrenze und ein senkrechtes Wachstum der Stengelkristalle zu erzeugen. Die Heizeinrichtung ist dabei so ausgebildet und angeordnet, daß die Kühlfinger auch durch die Heizkörper hindurch in die darüber liegendem Ausnehmungen angehoben werden können. Dies setzt einen erheblichen Bauaufwand und eine große Präzision in der Fertigung und Montage voraus. Durch den notwendigen Hub von Kühlplatte und Kühlkörpern - insbesondere bedingt durch die Höhe der Kühlkörper - werden ein erheblicher Freiraum unter der Wärmedämmplatte und damit eine beträchtliche Bauhöhe und ein zusätzliches Volumen der Kristallisationskammer bzw. der gesamten Vorrichtung erforderlich. Durch die laufende Veränderung der relativen Lage der Kühleinrichtung zur Kokille während des Erstarrungsprozesses ist es kaum möglich, den Erstarrungprozeß ohne störende Erschütterungen zu Ende zu führen.

Demgegenüber liegt der Erfindung die Aufgabe zugrunde, eine Vorrichtung der eingangs beschriebenen Gattung zu schaffen, die einfach und kompakt im Aufbau ist und eine erschütterungsfreie und reproduzierbare Produktion von gerichtet erstarrten Blöcken mit großen Querschnitten der Blöcke selbst und der Kristalle in industriellem Maßstab und mit kurzen Zeiten für die Chargierung und Dechargierung erlaubt. Insbesondere sollen dabei auch das Aufschmelzen der Charge in der Kokille selbst erfolgen und die Wanderung einer möglichst weitgehend ebenen Phasengrenze ermöglicht werden.

Die Lösung der gestellten Aufgabe erfolgt bei einer Vorrichtung nach dem Oberbegriff des Patentanspruchs 1 durch die Merkmale im Kennzeichen des Patentanspruchs 1.

Mit einer solchen Bauweise der Vorrichtung wird die gestellte Aufgabe in vollem Umfange gelöst, d.h., die Vorrichtung ist einfach und kompakt im Aufbau und erlaubt eine erschütterungsfreie und reproduzierbare Produktion von gerichtet erstarrten Blöcken mit großen Querschnitten der Blöcke selbst und der Kristalle in industriellem Maßstab und mit kurzen Zeiten für die Chargierung und Dechargierung. Insbeondere erfolgen dabei auch das Aufschmelzen der Charge in der Kokille selbst, und die Wanderung einer möglichst weitgehend ebenen Phasengrenze wird ermöglicht.

Die Vorrichtung ist insbesondere geeignet für die Herstellung großer quaderförmiger Blöcke bzw. Ingots und ermöglicht die kostengünstige Herstellung von hochreinen und großkristallinen Wafern für Solarzellen durch Zersägen der Blöcke in dünne Scheiben.

Besonders vorteilhafte Ausgestaltungen der Erfindung sind Gegenstand der Patentansprüche 2 und 11.

Weitere vorteilhafte Ausgestaltungen des Erfindungsgegenstandes, die entweder einzeln oder in Kombination angewendet werden können, sind in den übrigen Vorrichtungsansprüchen aufgeführt; ihre Vorteile werden in der Detailbeschreibung noch näher abgehandelt.

Die Erfindung betrifft auch ein Betriebsverfahren für eine solche Vorrichtung mit einem inneren Chargierbehälter. Dabei wird so verfahren, daß in der Kokille zunächst eine Teilmenge der gesamten Charge aufgeschmolzen wird und daß nachfolgend mindestens eine weitere im Chargierbehälter befindliche Charge aus Granulat in die Kokille nachchargiert und in dieser aufgeschmolzen wird, bevor die gerichtete Erstarrung durchgeführt wird.

Drei Ausführungsbeispiele der Erfindung werden nachfolgend anhand der Figuren 1 bis 9 näher erläutert.

Es zeigen:
- Figur 1: einen Vertikalschnitt durch ein erstes Ausführungsbeispiel einer geschlossene Kristallisationskammer im Betriebszustand,
- Figur 2: die Kristallisationskammer nach Figur 1 in auseinandergefahrenem Zustand und in verkleinertem Maßstab,
- Figur 3: eine schematische Darstellung eines zweiten Ausführungsbeispiels des oberen Kammerteils,
- Figur 4: eine schematische Darstellung eines zweiten Ausführungsbeispiels des unteren Kammerteils,
- Figur 5: eine schematische Darstellung der zusammengefahrenen Kammerteile nach den Figuren 3 und 4,
- Figur 6: die funktionswesentlichen Teile des Chargierbehälters für die Nachchargierung von Siliziumgranulat,
- Figur 7: die funktionswesentlichen Teile des Chargierbehälters für die Nachchargierung, ergänzt durch einen Führungskanal für das Siliziumgranulat,
- Figur 8: einen Vertikalschnitt durch ein drittes Ausführungsbeispiel einer geschlossene Kristallisationskammer im Betriebszustand, analog Figur 1, und
- Figur 9: die Kristallisationskammer nach Figur 8 in auseinandergefahrenem Zustand und in verkleinertem Maßstab.

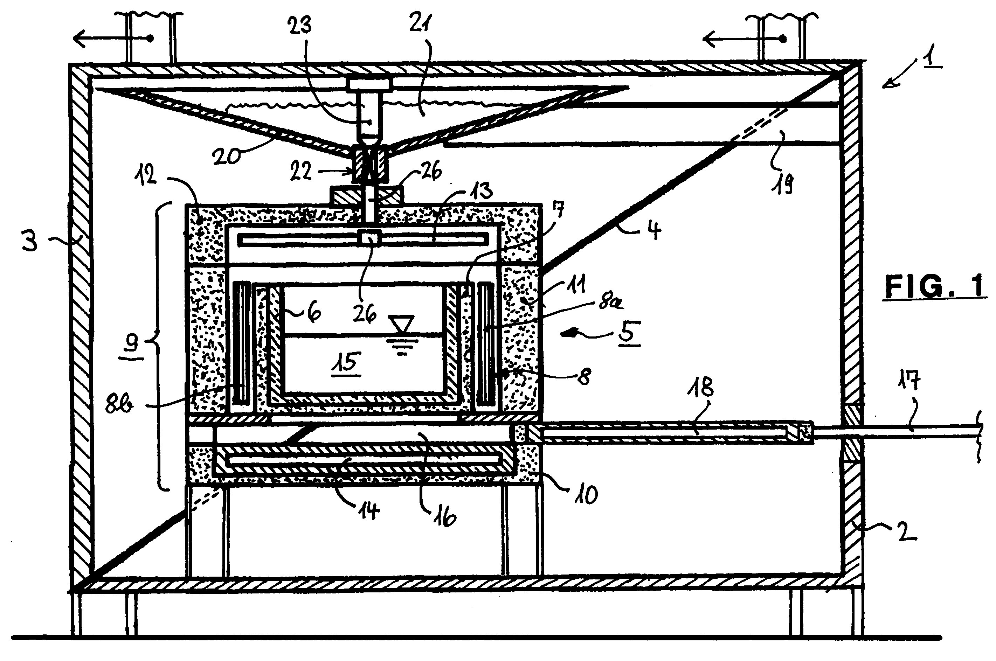

In Figur 1 ist eine gasdichte Kristallisationskammer 1 dargestellt, die die Form eines hohlen Quaders hat und aus einem Kammerunterteil 2 und einem Kammeroberteil 3 besteht, die an einer diagonalen Trennfuge 4 aneinanderstoßen. Die Dichtflansche sind der Einfachheit halber nicht dargestellt.

In der Kristallisationskammer 1 befindet sich eine Kristallisationseinrichtung 5, zu der eine quaderförmige Kokille 6 gehört, die eine obenliegende Kokillenöffnung 6a, innere Wände und einen Boden aus Siliziumdioxid (Quarz) und einen Behälter 7 aus Grafit mit einem Boden besitzt. Die Zarge der Kokille ist auf allen Seiten von einer Heizeinrichtung 8 umgeben, die unterteilt ist, was in den nachfolgenden Figuren noch näher dargestellt ist. Die Trennfuge 4 muß nicht genau diagonal verlaufen; sie muß es beim Öffnen der Kristallisationskammer 1 nur ermöglichen, daß die Kristallisationseinrichtung 5 gleichzeitig von oben und von mindestens einer Seite her zugänglich und in waagrechter Richtung zur Freilegung des Kokilleninhalts entnehmbar ist.

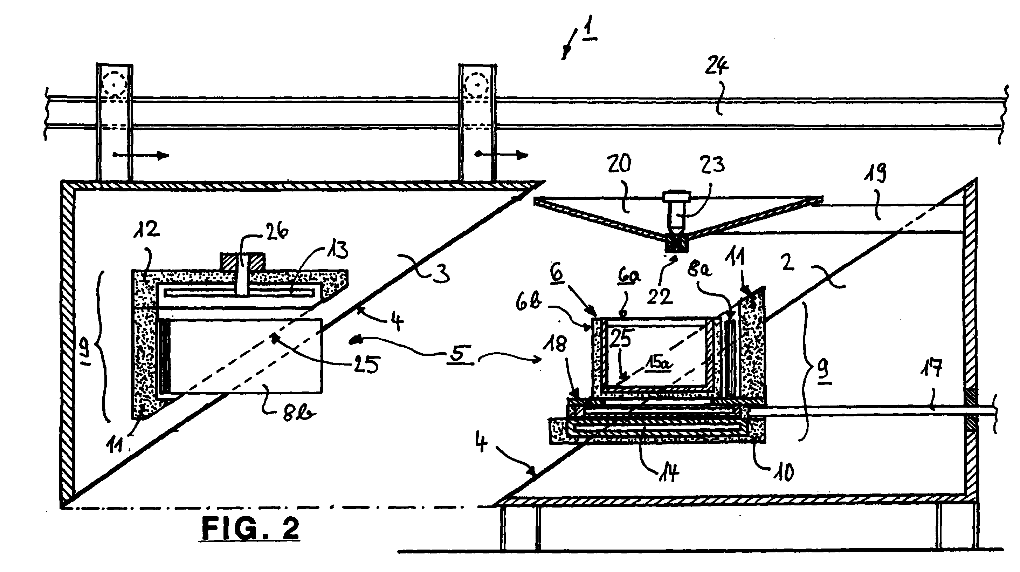

Die Anordnung aus Kokille 6 und Heizeinrichtung 8 ist von einer strahlungsdichten Wärmedämmeinrichtung 9 umgeben, die aus einem Boden 10, einer Zarge 11 und einem Deckel 12 besteht, unter dem eine plattenförmige Deckenheizeinrichtung 13 angeordnet ist. Auf dem Boden 10 und unterhalb der Kokille 6 ruht eine Bodenheizeinrichtung 14. Durch die Heizeinrichtungen 8, 13 und 14 läßt sich aus einchargiertem festem Siliziumgranulat eine Siliziumschmelze 15 erzeugen, in der nach dem Aufschmelzen eine zumindest nahezu isotherme Temperaturverteilung vorliegt. Zwischen der Bodenheizeinrichtung 14 und dem Boden des Behälters 7 befindet sich ein flacher, quaderförmigen Hohlraum 16, in den von der Seite her mittels einer Schubstange 17 ein Kühlschieber 18 einschiebbar ist. Durch das Einschieben des Kühlschiebers wird erreicht, daß die Wirkung der Bodenheizeinrichtung 14 aufgehoben und die bis dahin isotherme Temperaturverteilung so verändert wird, daß in der Schmelze 15 eine nahezu waagrechte Phasengrenze von unten nach oben wandert, die eine gerichtete Erstarrung der Schmelze zu einem Siliziumblock 15a (Figur 2) ermöglicht.

Oberhalb des Deckels 12 und konzentrisch zu diesem ist an dem Kammerunterteil 2 mittels eines Auslegers 19 ein Chargierbehälter 20 befestigt, der die Form einer flachen, auf dem Kopf stehenden 4-seitigen Pyramide hat und in dem eine weitere Charge 21 aus granulatförmigem Silizium angeordnet ist. An der Spitze dieser Pyramide befindet sich eine Chargieröffnung 22, die zunächst durch eine Stopfenstange 23 verschlossen ist. Damit hat es folgende Bewandnis: Der Deckel 12 gibt nach oben hin erhebliche Energiemengen durch Strahlung ab, die den Chargierbehälter 20 mit seinem Inhalt aufheizen. In diesem Bereich können Temperaturen von etwa 400 °C herrschen. Dadurch wird das Granulat sehr wirksam entgast und insbesondere von Wasser und/oder Wasserdampf befreit.

Das Volumen des in der Kokille 6 zunächst befindlichen Siliziumgranulats, das erhebliche Hohlräume enthält, ist durch den Aufschmelzprozeß auf etwa die Hälfte bis zwei Drittel geschrumpft, so daß die Kokille 6 nur teilweise gefüllt ist, was zu einer entsprechend geringeren Produktivität der Anlage führt. Durch Anheben der Stopfenstange 23 und Nachchargieren der vorgewärmten, getrockneten und/oder entgasten und sehr rieselfähigen Charge 21 wird das verfügbare Restvolumen der Kokille 6 aufgefüllt, wodurch die Produktivität entsprechend erhöht und bis nahezu verdoppelt wird. Außerdem wird das ansonsten erfolgende Spritzen der Schmelze durch Gasfreisetzung aus der neuen Charge in der Schmelze verhindert. Erst danach wird der Kühlschieber 18 eingeschoben und der Kristallisationsprozeß eingeleitet, der alsdann ungestört abläuft.

Die Figur 2 zeigt - gegenüber der Figur 1 verkleinert -, die Anlage in der Chargier- und Dechargierstellung: Das Kammeroberteil 3 wurde - an Fahrschienen 24 hängend - so weit nach links verfahren, daß die Kokille 6, die jetzt nahezu bis zu ihrem Rand mit einem gerichtet erstarrten Siliziumblock 15a gefüllt ist, von oben, von der Vorderseite 6b und teilweise auch von der Seiten her zugänglich ist und mittels einer nicht gezeigten Transportvorrichtung aus der Wärmedämmeinrichtung 9 entnommen werden kann. Zu diesem Zweck ist die Heizeinrichtung 8 in einen plattenförmigen Teilheizkörper 8a und einen U-förmigen Teilheizkörper 8b unterteilt, die in zusammengefahrenem Zustand (Figur 1) eine geschlossene Umfangsheizung bilden. Durch seitliches Verfahren des Kammeroberteils 3 in die Position gemäß Figur 2 wird jedoch der Teilheizkörper 8b mit nach links verfahren.

Auch die Wärmedämmeinrichtung 9 besitzt eine schräg verlaufende Trennfuge 25, deren Ebene parallel zur Trennfuge 4 verläuft und entlang welcher die Wärmedämmeinrichtung 9 gleichfalls geteilt werden kann. Die In Figur 2, links, gezeigten Teile der Kristallisationseinrichtung 5 sind im oberen Kammerteil 3 befestigt und mit diesem verfahrbar, also auch der linke Teil der Wärmedämmeinrichtung 9 mit dem Deckel 12 und mit der Deckenheizeinrichtung 13 und dem U-förmigen Teilheizkörper 8b. Die In Figur 2, rechts, gezeigten Teile der Kristallisationseinrichtung 5 sind im unteren Kammerteil 3 befestigt und mit diesem stationär, also auch der rechte Teil der Wärmedämmeinrichtung 9 mit dem Boden 10, der Bodenheizeinrichtung 14, dem plattenförmigen Teilheizkörper 8a und der Kokille 6. Stationär am unteren Kammerteil 2 ist auch der Ausleger 19 mit dem Chargierbehälter 20 befestigt.

Sowohl im Deckel 12 der Wärmedämmeinrichtung 9 als auch in der Deckenheizeinrichtung 13 sind etwa mittig miteinander fluchtende Fallrohre 26 angeordnet, die in zusammengefahrenem Zustand der Anlage gemäß Figur 1 auch mit der Chargieröffnung 22 fluchten, so daß das oben beschriebene Nachchargieren möglich ist.

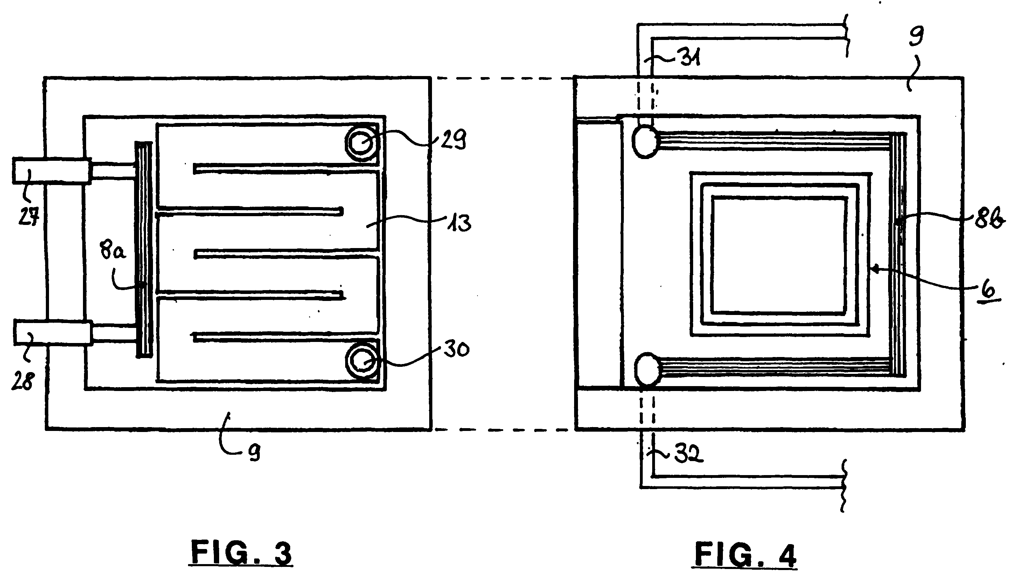

In Figur 3 ist - in der Draufsicht - der plattenförmige Teilheizkörper 8a am verfahrbaren oberen Kammerteil befestigt. Die Stromanschlüsse 27 und 28 sind durch den linken Teil der Wärmedämmeinrichtung 9 hindurchgeführt. Die Deckenheizeinrichtung 13 ist mäanderförmig ausgeführt. Deren Stromanschlüsse 29 und 30 sind durch den (hier nicht gezeigten) Deckel 12 hindurchgeführt.

In Figur 4 ist - in der Draufsicht - der U-förmige Teilheizkörper 8b am stationären unteren Kammerteil befestigt. Die Stromanschlüsse 31 und 32 sind durch die Seitenwände des rechten Teils der Wärmedämmeinrichtung 9 hindurchgeführt. In diesem Fall wird die Kokille 6 mittels einer Hubeinrichtung nach links entnommen, die beispielsweise Saugnäpfe aufweisen kann.

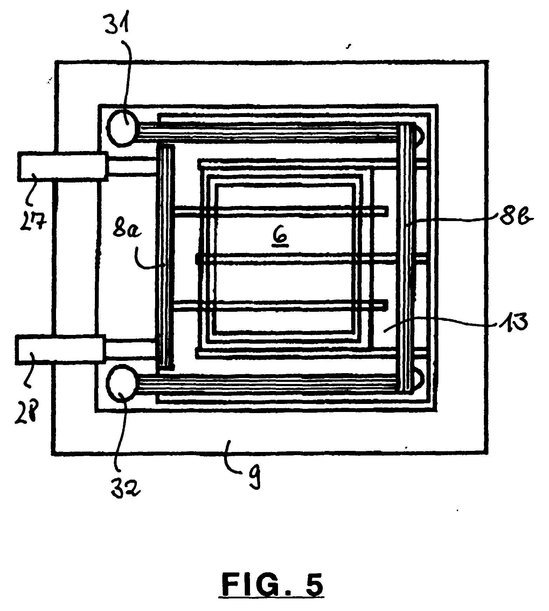

Figur 5 zeigt die beiden Baugruppen nach den Figuren 3 und 4 in zusammengefahrenem Zustand. Es ist zu sehen, daß die Teilheizeinrichtungen 8a und 8b die Zarge der Kokille 6 auf den gesamten Umfange strahlungsdicht umgeben.

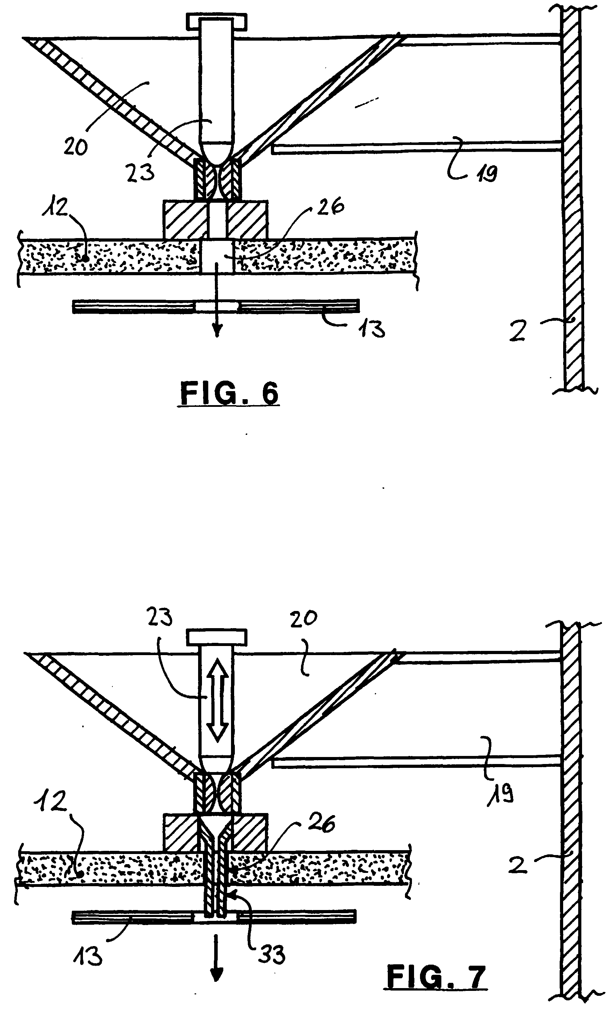

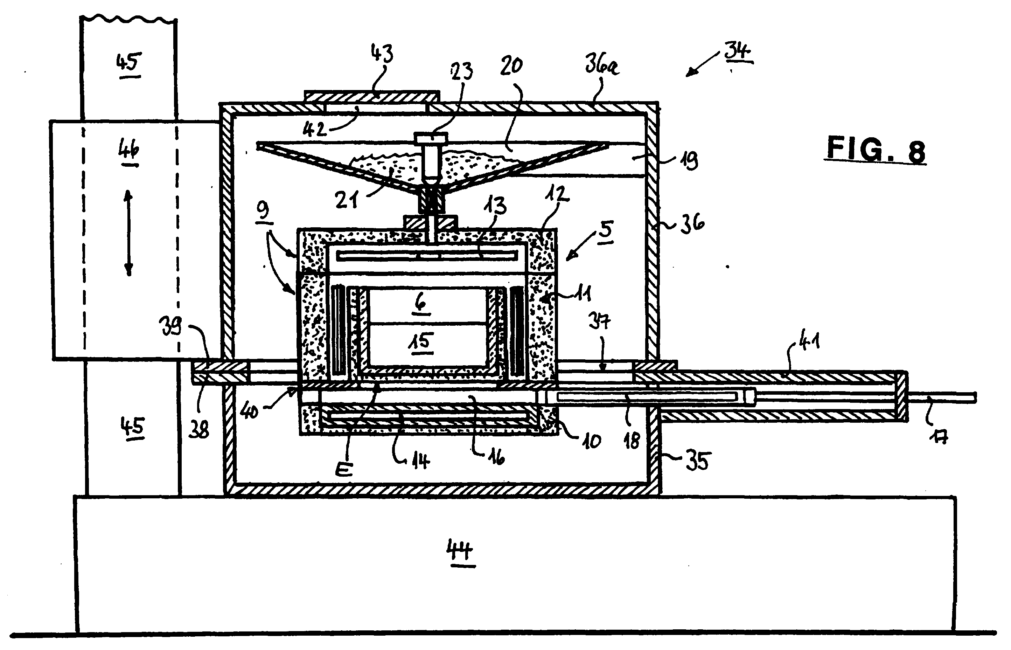

Die Figuren 6 und 7 zeigen - unter Verwendung der bisherigen Bezugszeichen - die funktionswesentlichen Teile des Chargierbehälters 20 für die Nachchargierung, in Figur 7 ergänzt durch einen Führungskanal 33 für das Siliziumgranulat. Die gute Rieselfähigkeit des Siliziumgranulats erlaubt eine sehr flache Bauweise des chargierbehälters 20 und dessen Unterbringung in der Kristallisationskammer 1.

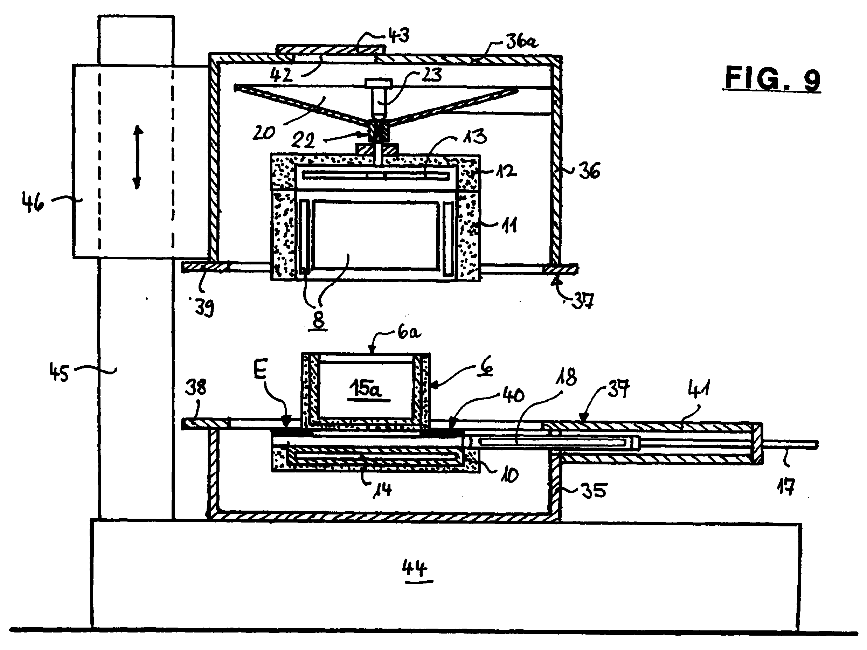

Für das dritte Ausführungsbeispiel nach den Figuren 8 und 9 werden, soweit es sich um gleiche Teile oder Teile mit gleicher Funktion handelt, die gleichen Bezugszeichen verwendet.

Die Kristallisationskammer 34 besteht gleichfalls aus einem Kammerunter- teil 35 und einem Kammeroberteil 36, die an einer Trennfuge 37 aneinanderstoßen, die in diesem Falle waagrecht verläuft und von zwei Flanschen 38 und 39 begrenzt wird. Die Trennfuge 37 liegt knapp oberhalb einer virtuellen Ebene "E", die durch einen rechteckigen Tragrahmen 40 gebildet wird, auf dem die Kokille 6 ruht. In dieser befindet sich die Schmelze 15, die aus der ersten festen Charge aus Siliziumgranulat gebildet wurde. Unterhalb der virtuellen Ebene "E" befinden sich der Kühlschieber 18, der in ein seitlich angesetztes Schiebergehäuse 41 zurückziehbar ist, und die Bodenheizeinrichtung 14. Oberhalb des Chargierbehälters 20 befindet sich in einer Decke 36a des Kammeroberteils 36 eine Chargieröffnung 42, die durch einen Chargierdeckel 43 verschließbar ist.

Die Kristallisationskammer 34 ruht auf einem Ofengestell 44, das nur schematisch dargestellt ist und an einer Seite eine Hubsäule 45 besitzt, an der eine angetriebene Vertikalführung 46 für das Kammeroberteil 36 geführt ist. Das Bauprinzip einer solchen Vorrichtung wird auch als "Haubenofen" bezeichnet.

Wie insbesondere aus Figur 9 hervorgeht, sind die Kokille 6, ihr Tragrahmen 40, der Kühlschieber 18, die Bodenheizeinrichtung 14 und der Boden 10 der Wärmedämmeinrichtung 9 dem Kammerunterteil 35 zugeordnet. Fest mit dem Kammeroberteil 36 verbunden sind hingegen die Kokillenheizeinrichtung 8, die in diesem Fall aus vier im Rechteck angeordneten plattenförmigen Heizelementen besteht, die Zarge 11 und der Deckel 12 der Wärmedämmeinrichtung 9, die Deckenheizeinrichtung 13 sowie der Chargierbehälter 20 für mindestens eine weitere Charge 21 (Figur 8). Die Befestigungsmittel sind der Einfachheit halber nicht dargestellt.

In der Chargier- und Dechargierstellung nach Figur 9 ist das Kammeroberteil 36 angehoben. Durch die vorstehend beschriebene Höhenlage der Ebene "E" und der Trennfuge 37 ist die Kokille 6 nach allen Seiten hin für eine nicht gezeigte Entnahmeeinrichtung zugänglich. Durch das weiter oben beschriebene Nachchargieren der Charge 21 (Figur 8) ist das

Volumen des jetzt gerichtet erstarrten Siliziumblocks 15a entsprechend gewachsen.

Wie alle Figuren zeigen, ist die Vorrichtung derart kompakt und kostengünstig aufgebaut, daß mehrere solcher Einheiten ohne weiteres an die Stelle einer Großanlage mit zentraler Schmelz- und Gießkammer nach der US 3 601 179 A gesetzt werden kann. Dadurch bleiben alle übrigen Einheiten betriebsfähig, wenn an einer der Einheiten Wartungs- und/oder Reparaturarbeiten durchgeführt werden.

Die Kokille 6 und der Behälter 7 sind mit festen Böden versehen, im Gegensatz also zu sog. Stranggußkokillen mit einem abziehbaren Boden.

Für die Heizeinrichtungen 8, 13 und 14 werden handelsübliche Materialien verwendet, beispielsweise Grafit, ggf. verstärkt durch Kohlefasern wie sog. CFC-Material (Kohlenstoff-Fasern-Kohlenstoff). Bei dem Ausführungsbeispiel nach den Figuren 8 und 9 kann für die Umfangsheizeinrichtung 8 auch eine Induktionsspule verwendet werden, da der aus Grafit bestehende Behälter 7 der Kokille 6 als Suszeptor für elektromagnetische Wellen wirkt. Für die Teile der Wärmedämmeinrichtung 9 kann beispielsweise Fasermaterial wie Grafitfilz verwendet werden oder auch Grafitfolien.

### Bezugszeichen:

- 1: Kristallisationskammer
- 2: Kammerunterteil
- 3: Kammeroberteil
- 4: Trennfuge
- 5: Kristallisationseinrichtung
- 6: Kokille
- 6a: Kokillenöffnung
- 7: Behälter
- 8: Heizeinrichtung
- 8a: Teilheizkörper
- 8b: Teilheizkörper
- 9: Wärmedämmeinrichtung
- 10: Boden
- 11: Zarge
- 12: Deckel
- 13: Deckenheizeinrichtung
- 14: Bodenheizeinrichtung
- 15: Siliziumschmelze
- 15a: Siliziumblock
- 16: Hohlraum
- 17: Schubstange
- 18: Kühlschieber
- 19: Ausleger
- 20: Chargierbehälter
- 21: Charge
- 22: Chargieröffnung
- 23: Stopfenstange
- 24: Fahrschienen
- 25: Trennfuge
- 26: Fallrohr
- 27: Stromanschluß
- 28: Stromanschluß
- 29: Stromanschluß
- 30: Stromanschluß
- 31: Stromanschluß
- 32: Stromanschluß
- 33: Führungskanal
- 34: Kristallisationskammer
- 35: Kammerunterteil
- 36: Kammeroberteil
- 36a: Decke
- 37: Trennfuge
- 38: Flansch
- 39: Flansch
- 40: Tragrahmen
- 41: Schiebergehäuse
- 42: Chargieröffnung
- 43: Chargierdeckel
- 44: Ofengestell
- 45: Hubsäule
- 46: Vertikalführung
- "E": Ebene

## Patentansprüche

1. Vorrichtung zum Herstellen von gerichtet erstarrten Blöcken (15a) aus Feststoffen, insbesondere aus Silizium, mit einer gasdichten Kristallisationskammer (1, 34), einer Kokille (6) mit einer Kokillenöffnung (6a), Kokillenwänden und einem Kokillenboden, mit einer Deckenheizeinrichtung (13) für die Beheizung der Kokillenöffnung (6a), mit einer Bodenheizeinrichtung (14) für die Beheizung des Kokillenbodens und mit einer Wärmedämmeinrichtung (9), die die Kokille (6) und die Heizeinrichtungen (13, 14) umgibt, wobei die Feststoffe in der Kokille (6) aufschmelzbar sind, **dadurch gekennzeichnet**, daß
a) die Kristallisationskammer (1, 34) entlang einer Trennfuge (4, 37) in ein stationäres Kammerunterteil (2, 35) und ein bewegliches Kammeroberteil (3, 36) unterteilt ist,
b) die Bodenheizeinrichtung (14) mit einem Boden (10) der Wärmedämmeinrichtung (9) und die Kokille (6) im Kammerunterteil (2, 35) angeordnet sind,
c) die Deckenheizeinrichtung (13) für Beheizung der Kokillenöffnung (6a) und ein Deckel (12) der Wärmedämmeinrichtung (9) am Kammeroberteil (3, 36) befestigt und mit diesem verfahrbar sind, und wobei
d) die Kokille (6) durch Verfahren des Kammeroberteils (3, 36) an mindestens einer Umfangsseite freilegbar ist.

2. Vorrichtung nach Anspruch 1, **dadurch gekennzeichnet**, daß die Trennfuge (4) unter einem Winkel von 20 bis 70 Grad zur Waagrechten verläuft.

3. Vorrichtung nach Anspruch 2, **dadurch gekennzeichnet**, daß die Trennfuge (4) unter einem Winkel von 30 bis 60 Grad zur Waagrechten verläuft.

4. Vorrichtung nach Anspruch 1, **dadurch gekennzeichnet**, daß eine Heizeinrichtung (8) für die Beheizung der Kokillenwände vorgesehen ist, die auf dem Umfang in einen ersten Teilheizkörper (8a) und einen zweiten Teilheizkörper (8b) unterteilt ist, wobei die Bodenheizeinrichtung (14) und der erste Teilheizkörper (8a) im Kammerunterteil (2) angeordnet sind und der zweite Teilheizkörper (8b) ebenso wie die Deckenheizeinrichtung (13) für Beheizung der Kokillenöffnung (6a) am Kammeroberteil (3) befestigt und mit diesem mit einer seitlichen Bewegungskomponente verfahrbar sind.

5. Vorrichtung nach Anspruch 4, **dadurch gekennzeichnet**, daß die Heizeinrichtung (8) für die Beheizung der Kokillenwände asymmetrisch unterteilt ist, wobei der eine Teilheizkörper (8a) plattenförmig und der andere Teilheizkörper (8b) U-förmig ausgebildet ist und wobei sich die beiden Teilheizkörper (8a, 8b) zu einem Rechteck ergänzen.

6. Vorrichtung nach Anspruch 4, **dadurch gekennzeichnet**, daß die Heizeinrichtung (8) für die Beheizung der Kokillenwände diagonal unterteilt ist.

7. Vorrichtung nach Anspruch 4, **dadurch gekennzeichnet**, daß der plattenförmige Teilheizkörper (8a) im stationären Kammerunterteil (2) und der U-förmige Teilheizkörper (8b) im verfahrbaren Kammeroberteil (3) befestigt ist.

8. Vorrichtung nach Anspruch 4, **dadurch gekennzeichnet**, daß der plattenförmige Teilheizkörper (8a) im verfahrbaren Kammeroberteil (3) und der U-förmige Teilheizkörper (8b) im stationären Kammerunterteil (2) befestigt ist.

9. Vorrichtung nach Anspruch 1, **dadurch gekennzeichnet**, daß die Wärmedämmeinrichtung (9) eine Zarge (11) besitzt, die entlang einer weiteren Trennfuge (25) unterteilt ist, die unter einem Winkel von 20 bis 70 Grad zur Waagrechten verläuft,

10. Vorrichtung nach Anspruch 9, **dadurch gekennzeichnet**, daß die Trennfuge (25) der Wärmedämmeinrichtung unter einem Winkel von 30 bis 60 Grad zur Waagrechten verläuft,

11. Vorrichtung nach Anspruch 1, **dadurch gekennzeichnet**, daß am stationären Kammerunterteil (2) ein Chargierbehälter (20) zum Nachchargieren von Granulat in die Kokille (6) befestigt ist.

12. Vorrichtung nach Anspruch 1, **dadurch gekennzeichnet**, daß
a) die Trennfuge (37) waagrecht verläuft,
b) die Bodenheizeinrichtung (14) und ein Boden (10) der Wärmedämmeinrichtung (9) sowie ein Tragrahmen (40) für die Kokille (6) und die Kokille (6) selbst im Kammerunterteil (35) angeordnet sind,
c) die Deckenheizeinrichtung (13) für Beheizung der Kokillenöffnung (6a) und ein Deckel (12) der Wärmedämmeinrichtung (9) am Kammeroberteil (36) befestigt und mit diesem in vertikaler Richtung verfahrbar sind.

13. Vorrichtung nach Anspruch 12, **dadurch gekennzeichnet**, daß eine Heizeinrichtung (8) für die Beheizung der Kokillenwände vorgesehen ist, die am Kammeroberteil (36) befestigt ist.

14. Vorrichtung nach Anspruch 12, **dadurch gekennzeichnet**, daß die Trennfuge (37) in einer solchen Höhe angeordnet ist, daß zumindests der größte Teil der Höhe der Kokille (6) nach dem Anheben des Kammeroberteils (36) von mindestens einer Seite her freilegbar ist.

15. Vorrichtung nach Anspruch 12, **dadurch gekennzeichnet**, daß am verfahrbaren Kammeroberteil (36) ein Chargierbehälter (20) zum Nachchargieren von Granulat in die Kokille (6) befestigt ist.

16. Vorrichtung nach einem der Ansprüche 11 und 15, **dadurch gekennzeichnet**, daß der Chargierbehälter (20) durch Abwärme des Deckenheizkörpers (13) beheizbar ist.

17. Vorrichtung nach Anspruch 16, **dadurch gekennzeichnet**, daß der Chargierbehälter (20) an seiner tiefsten Stelle eine Chargieröffnung (22) besitzt und daß sowohl in einem Deckel (12) der Wärmedämmeinrichtung (9) als auch in der Deckenheizeinrichtung (13) oberhalb der Kokille (6) Öffnungen für den Durchtritt der Charge (21) angeordnet sind.

18. Vorrichtung nach Anspruch 16, **dadurch gekennzeichnet**, daß der Chargierbehälter (20) als hohle, auf dem Kopf stehende vierseitige Pyramide ausgeführt ist.

19. Vorrichtung nach Anspruch 16, **dadurch gekennzeichnet**, daß die Chargieröffnung (22) mittels einer Stopfenstange (23) verschließbar ist.

20. Vorrichtung nach Anspruch 2, **dadurch gekennzeichnet**, daß das Kammeroberteil (3) an Fahrschienen (24) waagrecht verfahrbar aufgehängt ist.

21. Vorrichtung nach Anspruch 12, **dadurch gekennzeichnet**, daß das Kammeroberteil (36) an einer Hubsäule (45) vertikal verfahrbar ist.

22. Betriebsverfahren für die Vorrichtung nach Anspruch 1 und einem der Ansprüche 11 und 15, **dadurch gekennzeichnet**, daß in der Kokille (6) zunächst eine Teilmenge der gesamten Charge aufgeschmolzen wird und daß nachfolgend mindestens eine weitere im Chargierbehälter (20) befindliche Charge (21) aus Granulat in die Kokille (6) nachchargiert und in dieser aufgeschmolzen wird, bevor die gerichtete Erstarrung durchgeführt wird.
